# EUROPEAN PATENT SPECIFICATION

(11) **EP 3 148 302 B1**
(45) Date of publication and mention of the grant of the patent: **21.10.2020**
(21) Application number: 15815142.3
(22) Date of filing: 11.06.2015
(51) Int. Cl.: H05K 5/06, F16L 5/02

(54) **RADIO-FREQUENCY MODULE WATERPROOF STRUCTURE AND RADIO-FREQUENCY MODULE HAVING SAME**
WASSERDICHTE HOCHFREQUENZMODULSTRUKTUR UND HOCHFREQUENZMODUL DAMIT
STRUCTURE IMPERMÉABLE À L'EAU DE MODULE RADIOFRÉQUENCE ET MODULE RADIOFRÉQUENCE COMPORTANT UNE TELLE STRUCTURE

(30) Priority: 30.06.2014 CN 201420356817 U
(43) Date of publication of application: 29.03.2017
(73) Proprietor: Huawei Technologies Co., Ltd., Longgang District Shenzhen, Guangdong 518129 (CN)
(72) Inventor: HE, Chaoguo, Shenzhen Guangdong 518129 (CN); LI, Yongping, Shenzhen Guangdong 518129 (CN); ZHANG, Wanshan, Shenzhen Guangdong 518129 (CN); LI, Haipeng, Shenzhen Guangdong 518129 (CN)
(74) Representative: Thun, Clemens
(86) International application number: PCT/CN2015/081257
(87) International publication number: WO 2016/000519

(56) References cited:
- EP-A1- 1 633 015
- CN-A- 101 039 019
- CN-A- 101 047 397
- CN-U- 201 944 431
- CN-U- 202 678 614
- CN-U- 204 046 987
- DE-U1-202012 101 639
- US-A1- 2012 057 388

## Description

### TECHNICAL FIELD

The present invention relates to communications devices, and in particular, to a radio frequency module waterproof structure and a device.

### BACKGROUND

For example, DE 20 2012 101 639 U1 refers to a housing for one or more cables, comprising a housing lower part, which is designed to be arranged on a housing, and a housing upper part, which is delimited by an open state, at least one cable feedthrough seal being arranged at least in the housing lower part for accommodating a housing part, the housing bottom part being arranged in a closed state in which it is fastened to the lower housing part and wherein one or more fastening means for attaching the lower housing part to an electrical subassembly in an inner space is provided.

Radio frequency modules such as an outdoor building baseband unit BBU (Building Base band Unit) need to have very high environmental adaptability. With development of a miniaturization trend of outdoor radio frequency modules, it becomes more difficult to implement multi-cable waterproof design in the radio frequency modules. A cable of an existing radio frequency module is inserted into a rubber ring, and then the rubber ring is sealed and fastened at a module housing, to achieve waterproofing. However, this waterproof structure has low mounting efficiency, high operation space requirements, and high costs.

### SUMMARY

An objective of the present invention is to provide a radio frequency module waterproof structure, so as to resolve technical problems of poor assembly efficiency and complex operation. The invention is defined by the features of claim 1. Further embodiments are defined in the dependent claims.

According to one aspect, the waterproof structure is provided, including a case body, a cover body, a first sealing layer, a middle sealing layer, and a second sealing layer, the first sealing layer is mounted on the case body, and the second sealing layer is mounted on the cover body and is arranged opposite to the first sealing layer; the cover body covers the case body, and the middle sealing layer is sandwiched between the first sealing layer and the second sealing layer; at least two first jacks are formed at a junction of the first sealing layer and the middle sealing layer; and at least two second jacks are formed at a junction of the second sealing layer and the middle sealing layer, and the at least two first sealed through holes and the at least two second jacks are distributed at two layers, one above the other, and are arranged in a staggered manner, wherein a support body is wrapped inside the middle sealing layer, and the support body and the middle sealing layer are formed by means of insert molding, wherein the support body is a metal piece that has a same shape as that of the middle sealing layer and a size smaller than that of the middle sealing layer.

In a first implementation form of the first aspect at least two adjacently-arranged first grooves that have arc-shaped cross sections are disposed on a surface that is of the first sealing layer and that faces the middle sealing layer, second grooves corresponding to the first grooves are disposed at the middle sealing layer, and the second grooves and the first grooves are correspondingly coupled to form the first jacks.

In a second implementation form of the first aspect at least two adjacently-arranged third grooves that have arc-shaped cross sections are disposed on a surface that is of the second sealing layer and that faces the middle sealing layer, fourth grooves corresponding to the third grooves are disposed at the middle sealing layer, and the third grooves and the fourth grooves are correspondingly coupled to form the second jacks.

In a third implementation form of the first aspect the first sealing layer includes a first mounting surface and two opposite first end surfaces connected to the first mounting surface, and the at least two first grooves are adjacently disposed on the first mounting surface, and two ends of the at least two first grooves penetrate the two first end surfaces.

In a fourth implementation form of the first aspect the middle sealing layer further includes two oppositely-arranged second mounting surfaces and two oppositely-arranged second end surfaces, the two second end surfaces are respectively connected to the two second mounting surfaces, and the second grooves are disposed on one of the second mounting surfaces; and the at least two third grooves are disposed on the other second mounting surface, and two ends of the second grooves and two ends of the at least two third grooves penetrate the two second end surfaces.

In a fifth implementation form of the first aspect the first sealing layer and the middle sealing layer are connected by using a connection strip.

In a sixth implementation form of the first aspect the first sealing layer and the middle sealing layer are connected by means of integrated molding, and the first jacks are through holes that have round cross sections and that are disposed at the junction of the first sealing layer and the middle sealing layer.

In a seventh implementation form of the first aspect the first sealing layer is connected to first plugs corresponding to the first jacks; and the middle sealing layer is connected to second plugs corresponding to the second jacks.

In an eighth implementation form of the first aspect multiple annular recessed portions are disposed in inner peripheral walls of the first and the second jacks; and protrusions opposite to the recessed portions are disposed at outer peripheral edges of the first and the second plugs.

In a ninth implementation form of the first aspect the second sealing layer, and the middle sealing layer are made of a rubber material.

According to a second aspect, a radio frequency module is provided, including the radio frequency module waterproof structure according to any manner of the first aspect, where external high-density cables of the radio frequency module are inserted into the first jacks and second jacks, a cover body is fastened to the case body, the first sealing layer, the second sealing layer, and the middle sealing layer are sandwiched by the cover body and the case body, and the first sealing layer, the second sealing layer, and the middle sealing layer seal the high-density cables.

According to the radio frequency module waterproof structure of the present utility model, multiple separate cable jacks are disposed between the first sealing layer and a second sealing layer, and a cable can be easily inserted and connected by opening a cover body; and then the first sealing layer and the second sealing layer are tightly pressed to deform, so as to fasten and waterproof multiple cables simultaneously. In addition, the radio frequency module waterproof structure has a simple structure, can be operated conveniently and rapidly, and is more applicable to miniaturized modules.

### BRIEF DESCRIPTION OF DRAWINGS

To describe the technical solutions in the embodiments of the present invention or in the prior art more clearly, the following briefly describes the accompanying drawings required for describing the embodiments or the prior art.
FIG. 1 is a schematic exploded view of a radio frequency module waterproof structure according to an embodiment of the present invention
FIG. 2 is a schematic exploded view in another angle of a radio frequency module waterproof structure shown in FIG. 1;
FIG. 3 is a schematic structural diagram of a part of a radio frequency module waterproof structure shown in FIG. 1;
FIG. 4 is a schematic structural diagram of a part of a radio frequency module waterproof structure shown in FIG. 2;
FIG. 5 is a schematic structural diagram of a case body of a radio frequency module waterproof structure shown in FIG. 1;
FIG. 6 is a schematic structural diagram of a cover body of a radio frequency module waterproof structure shown in FIG. 1;
FIG. 7 is a schematic structural diagram of assembly of a radio frequency module waterproof structure shown in FIG. 1, but does not include a cover body;
FIG. 8 is a sectional view in an XII-XII direction of a radio frequency module waterproof structure shown in FIG. 7, but does not include a case body or a cover body; and
FIG. 9 is a schematic structural diagram of overall assembly of a radio frequency module waterproof structure shown in FIG. 1.

### DESCRIPTION OF EMBODIMENTS

The following clearly and completely describes the technical solutions in the embodiments of the present invention with reference to the accompanying drawings.

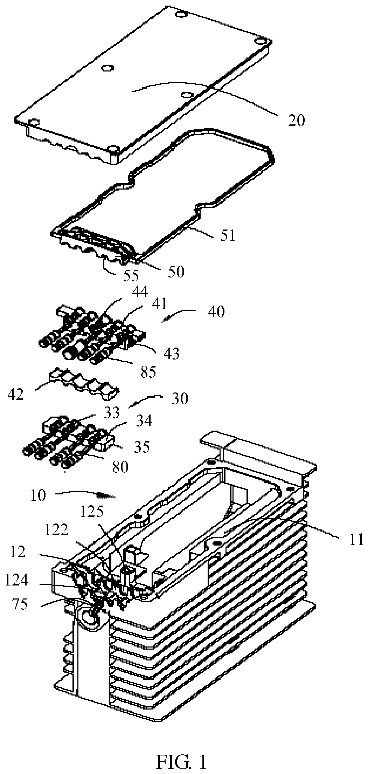

Referring to FIG. 1, FIG. 3, and FIG. 9, an embodiment of the present invention provides a radio frequency module waterproof structure. The radio frequency module waterproof structure includes a case body 10, a cover body 20, a first sealing layer 30, a middle sealing layer 40, and a second sealing layer 50. The first sealing layer 30 is mounted on the case body 10, and the second sealing layer 50 is mounted on the cover body 20 and is arranged opposite to the first sealing layer 30; the cover body 20 covers the case body 10, and the middle sealing layer 40 is sandwiched between the first sealing layer 30 and the second sealing layer 50; at least two first jacks 60 are formed at a junction of the first sealing layer 30 and the middle sealing layer 40; and at least two second jacks 70 are disposed at a junction of the second sealing layer 50 and the middle sealing layer 40, and the at least two first jacks 60 and the at least two second jacks 70 are distributed at two layers, one above the other, and are arranged in a staggered manner.

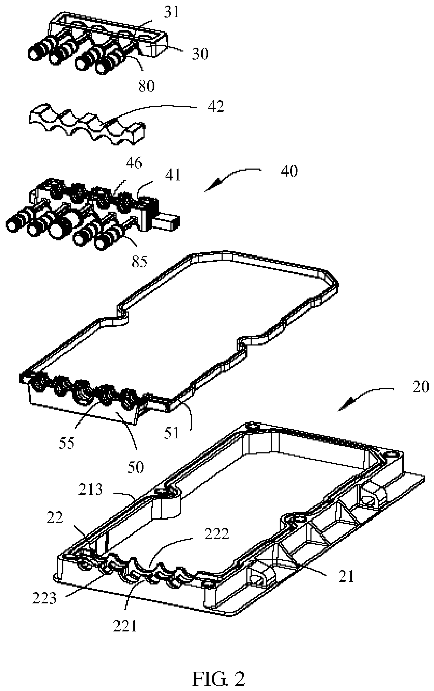

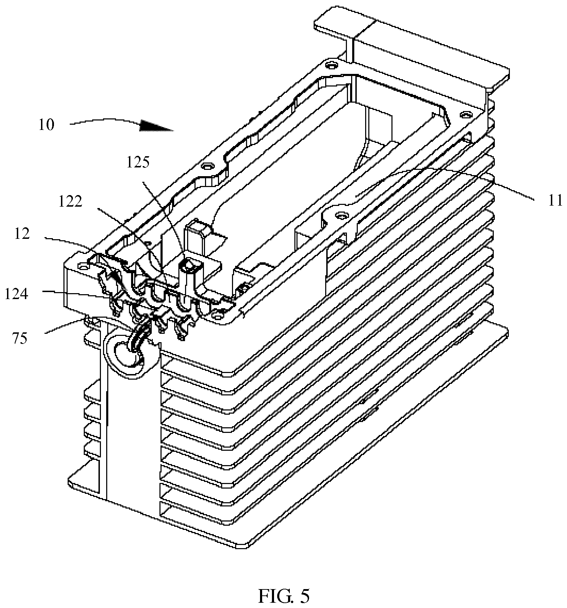

Referring to FIG. 2 and FIG. 5, in this embodiment, the first sealing layer 30, the second sealing layer 50, and the middle sealing layer 40 are made of a rubber material. There are four first jacks 60, and five second jacks 70. The four first jacks 60 are arranged in parallel in a same plane, the second jacks 70 are arranged in parallel in a same plane, and are parallel to the plane in which the first jacks 60 are located, and positions of the four first jacks 60 and opposite to positions between the five second jacks 70. The case body 10 is a radio frequency module housing, and has a front surface 11. A first assembly groove 12 is disposed at an edge of one end of the front surface 11. The first assembly groove 12 is a long-strip-shaped groove, and includes a groove bottom wall (not shown in the figure), opposite groove side walls 122 at two sides of the groove bottom wall, and groove end walls at two ends of the groove bottom wall (not shown in the figure). Multiple spaced clamping protrusions 124 protrude from the groove bottom wall. Gaps 125 corresponding to the first jacks 60 are disposed on each of the two groove side walls 122. The two groove end walls tilt towards the groove bottom wall. Multiple clamping grooves 31 are disposed on a surface that is of the first sealing layer 30 and far from the middle sealing layer 40. The first sealing layer 30 is accommodated in the first assembly groove 12, and the clamping protrusions 124 and the clamping grooves 31 perform clamping, so as to fasten the first sealing layer 30.

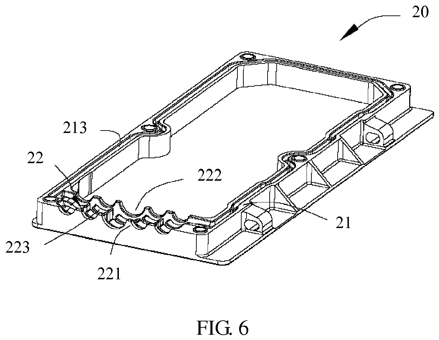

Referring to FIG. 6, the cover body 20 has a back surface 21. A second assembly groove 22 opposite to the first assembly groove 12 is disposed on the back surface 21. The second assembly groove 22 includes two groove side walls 221 and a groove bottom wall (not shown in the figure). Gaps 222 corresponding to the second jacks 70 are disposed on the groove side walls 221. Protrusions 223 protrude from the groove bottom wall of the second assembly groove 22. A groove 213 is disposed at a peripheral edge of the back surface 21. The groove 213 is connected to two ends of the second assembly groove 22, and communicates with the second assembly groove 22. The second sealing layer 50 is a strip-shaped block body, two opposite ends of the second sealing layer 50 tilt towards the first jacks 60, one annular sealing strip 51 corresponding to the groove 213 extends from one end wall of the second sealing layer 50, and the sealing strip 51 is connected to the other end wall. The second sealing layer 50 is accommodated in the second assembly groove, and the sealing strip 51 is accommodated in the groove 213. Multiple external cables of the radio frequency module are inserted into the first jacks 60 and the second jacks 70, and the cover body 20 is locked on the case body 10 by means of a screw and the like. The first sealing layer 30 and the second sealing layer 50 press the middle sealing layer 40 tightly, and therefore, each cable is waterproofed by means of a tight fit between the middle sealing layer 40 and each of the first sealing layer 30 and the second sealing layer 50.

According to the radio frequency module waterproof structure of the present invention, multiple separate cable jacks are disposed between a first sealing layer 30 and a second sealing layer 50, and a cable can be easily inserted and connected by opening a cover body 20; and then the first sealing layer 30 and the second sealing layer 50 are tightly pressed to deform, so as to fasten and waterproof multiple cables simultaneously. In addition, the radio frequency module waterproof structure has a simple structure, can be operated conveniently and rapidly, and is more applicable to miniaturized modules.

Further, a support body 42 is wrapped inside the middle sealing layer 40, and the support body 42 and the middle sealing layer 40 are formed by means of insert molding. In this embodiment, the support body 42 is a metal piece that has a same shape as that of the middle sealing layer 40 and a size smaller than that of the middle sealing layer 40. The support body 42 can improve a sealing effect of the middle sealing layer 40, so that the first jacks 60 and the second jacks 70 can implement a capability of preventing external foreign matter contamination, and better waterproof cables. In addition, the support body 42 is disposed at the middle sealing layer 40, and when the cables are inserted, the cables can be assembled with the first and the second jacks and positioned more accurately.

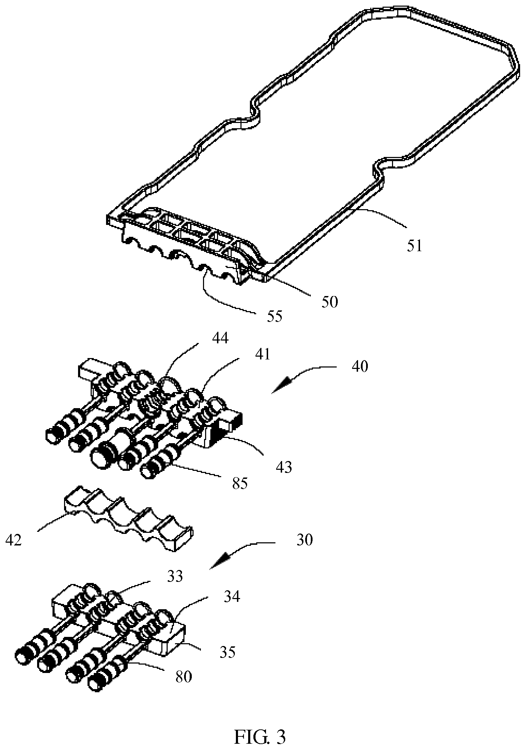

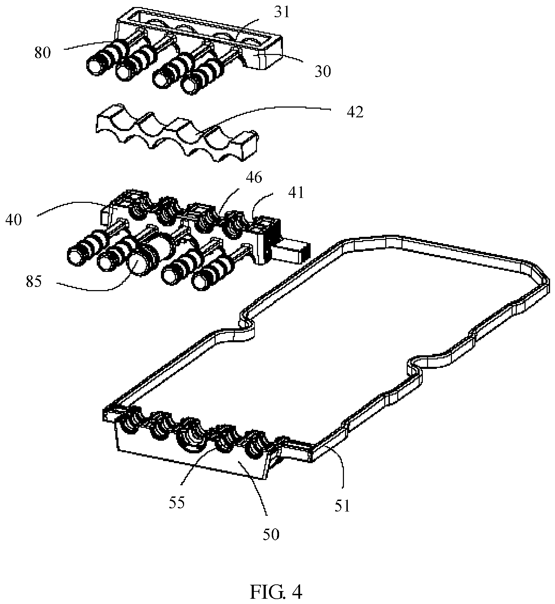

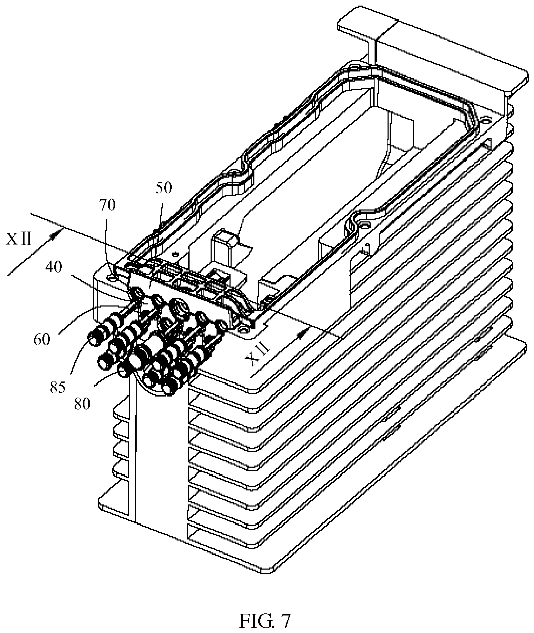

Referring to FIG. 3, FIG. 4, FIG. 7, and FIG. 8, further, at least two adjacently-arranged first grooves 33 that have arc-shaped cross sections are disposed on a surface that faces the middle sealing layer 40, of the first sealing layer 30, second grooves 44 corresponding to the first grooves 33 are disposed at the middle sealing layer 40, and the second grooves 44 and the first grooves 33 are correspondingly coupled to form the first jacks 60. In this embodiment, a connecting strip 75 is further disposed between the middle sealing layer 40 and the first sealing layer 30. The first groove 33 is a long-strip-shaped groove with an arc-shaped cross section. The middle sealing layer 40 and the first sealing layer 30 are fit, so that the second grooves 44 and the first grooves 33 are correspondingly coupled to form the first jacks 60. When cables are inserted, the middle sealing layer is opened, the cables are put into the first grooves 33, and then the middle sealing layer 40 is mounted. The connecting strip 75 prevents the middle sealing layer 40 from departing from the case body 10. In another embodiment of the present invention, the first sealing layer 30 and the middle sealing layer 40 are integrally connected, and the first jacks 60 are through holes that have round cross sections and that are disposed at the junction of the first sealing layer 30 and the middle sealing layer 40.

Further, the first sealing layer 30 further includes a first mounting surface 34 and two opposite first end surfaces 35 connected to the first mounting surface 34, the at least two first grooves 33 are adjacently disposed on the first mounting surface 34, and two ends of the at least two first grooves 33 penetrate the two first end surfaces 35. The first sealing layer 30 is connected to first plugs 80 corresponding to the first jacks 60, and the middle sealing layer 40 is connected to second plugs 85 corresponding to the second jacks 70. The first plugs 80 and the second plugs 85 are made of a rubber material. The first plugs 80 may be inserted into the first jacks 60 to achieve a protective effect. The second plugs 85 may be inserted into the second jacks 70 to achieve a protective effect.

Further, at least two adjacently-arranged third grooves 55 that have arc-shaped cross sections are disposed on a surface that is of the second sealing layer 50 and that faces the middle sealing layer 40, fourth grooves 46 corresponding to the third grooves 55 are disposed at the middle sealing layer 40, and the third grooves 55 and the fourth grooves 46 are correspondingly coupled to form the second jacks 70.

Further, the middle sealing layer 40 further includes two oppositely-arranged second mounting surfaces 41 and two oppositely-arranged second end surfaces 43, the two second end surfaces 43 are respectively connected to the two second mounting surfaces 41, and the second grooves 44 are disposed on one of the second mounting surfaces 41; and the at least two third grooves 46 are disposed on the other second mounting surface 41, and two ends of the second grooves 44 and two ends of the at least two third grooves 46 penetrate the two second end surfaces 43.

Further, annular recessed portions (not shown in the figure) are disposed in inner peripheral walls of the first jacks 60 and the second jacks 70, and multiple protrusions (not shown in the figure) opposite to the recessed portions are disposed at outer peripheral edges of the first plugs 80 and the second plugs 85. The first plugs 80 are inserted into the first jacks 60, the second plugs 85 are inserted into the second jacks 70, and the recessed portions and the protrusions work together to achieve a better sealing effect. In this embodiment, the recessed portions in the first jacks 60 are formed by correspondingly coupling semicircular recessed portions, where the semicircular recessed portions are disposed in inner walls of the first grooves 33 and the second grooves 44. The protrusions in the second jacks 70 are formed by correspondingly coupling semicircular recessed portions, where the semicircular recessed portions are disposed in inner walls of the third grooves 46 and the fourth

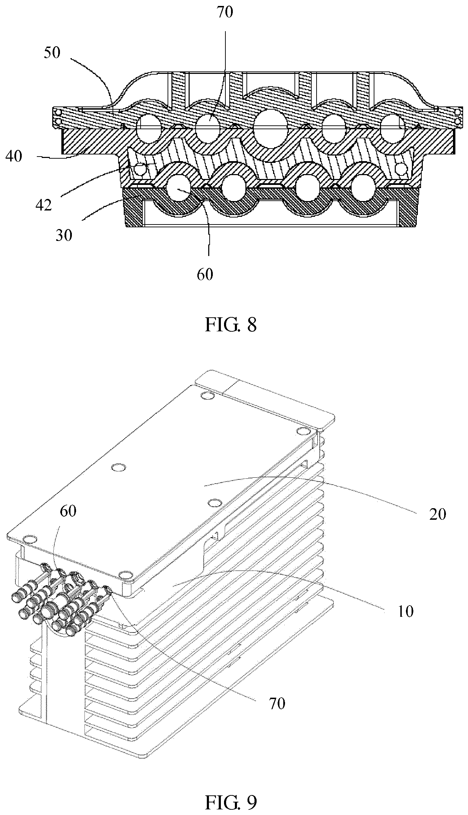

Referring to FIG. 9, the present invention further provides a radio frequency module. The radio frequency module includes the foregoing radio frequency module waterproof structure. External high-density cables of the radio frequency module are inserted into the first jacks 60 and second jacks 70, a cover body 20 is fastened to the case body 10, the first sealing layer 30, a second sealing layer 50, and a middle sealing layer 40 are sandwiched by the cover body 20 and the case body 10, and the first sealing layer 30, the second sealing layer 50, and the middle sealing layer 40 seal the high-density cables. In this embodiment, when cables are inserted, the cover body 20 is opened; the second sealing layer 50 is turned over relative to the middle sealing layer 40 along with the cover body 20. Then, the middle sealing layer 40 is removed to expose first grooves 33 of the first sealing layer 30. Cables are put into the first grooves 33. The middle sealing layer 40 is fit on the first sealing layer 30, and therefore, the cables are accommodated in the first jacks 60. The other cables are put into third grooves 46 of the middle sealing layer 40; the cover body 20 is mounted, so that the second sealing layer 50 is fit with the middle sealing layer, and therefore, the cables are put in the second jacks 70; the cover body 20 is tightly locked on the case body 10; and the first sealing layer 30, the second sealing layer 50, and the middle sealing layer 40 are pressed so as to fasten and seal the cables. In assembling and disassembling processes, operation is very simple, and multiple cables can be inserted simultaneously, and fastened simultaneously.

## Claims

1. A radio frequency module waterproof structure, wherein the waterproof structure comprises a case body (10), a cover body (20), a first sealing layer (30), a middle sealing layer (40), and a second sealing layer (50), the first sealing layer (30) is mounted on the case body (10), and the second sealing layer (50) is mounted on the cover body (20) and is arranged opposite to the first sealing layer (30); the cover body (20) covers the case body (10), and the middle sealing layer (40) is sandwiched between the first sealing layer (30) and the second sealing layer (50); at least two first jacks (60) are formed at a junction of the first sealing layer (30) and the middle sealing layer (40); and at least two second jacks (70) are formed at a junction of the second sealing layer (50) and the middle sealing layer (40), and the at least two first jacks (60) and the at least two second jacks (70) are distributed at two layers, one above the other, and are arranged in a staggered manner, wherein a support body (42) is wrapped inside the middle sealing layer (40), and the support body (42) and the middle sealing layer (40) are formed by means of insert molding, wherein the support body (42) is a metal piece that has a same shape as that of the middle sealing layer (40) and a size smaller than that of the middle sealing layer (40).

2. The radio frequency module waterproof structure according to claim 1, wherein at least two adjacently-arranged first grooves (33) that have arc-shaped cross sections are disposed on a surface that is of the first sealing layer (30) and that faces the middle sealing layer (40), second grooves (44) corresponding to the first grooves (33) are disposed at the middle sealing layer (40), and the second grooves (44) and the first grooves (33) are correspondingly coupled to form the first jacks (60).

3. The radio frequency module waterproof structure according to claim 2, wherein at least two adjacently-arranged third grooves (55) that have arc-shaped cross sections are disposed on a surface that is of the second sealing layer (50) and that faces the middle sealing layer (40), fourth grooves (46) corresponding to the third grooves (55) are disposed at the middle sealing layer (40), and the third grooves (55) and the fourth grooves (46) are correspondingly coupled to form the second jacks (70).

4. The radio frequency module waterproof structure according to claim 2, wherein the first sealing layer (30) comprises a first mounting surface (34) and two opposite first end surfaces (35) connected to the first mounting surface (34), and the at least two first grooves (33) are adjacently disposed on the first mounting surface (34), and two ends of the at least two first grooves (33) penetrate the two first end surfaces (35).

5. The radio frequency module waterproof structure according to claim 3, wherein the middle sealing layer (40) further comprises two oppositely-arranged second mounting surfaces (41) and two oppositely-arranged second end surfaces (43), the two second end surfaces (43) are respectively connected to the two second mounting surfaces (41), and the second grooves (44) are disposed on one of the second mounting surfaces (41); and the at least two third grooves (46) are disposed on the other second mounting surface (41), and two ends of the second grooves (46) and two ends of the at least two third grooves (46) penetrate the two second end surfaces (43).

6. The radio frequency module waterproof structure according to any one of claims 1 to 5, wherein the first sealing layer (30) and the middle sealing layer (40) are connected by using a connection strip.

7. The radio frequency module waterproof structure according to claim 1, wherein the first sealing layer (30) and the middle sealing layer (40) are connected by means of integrated molding, and the first jacks (60) are through holes that have round cross sections and that are disposed at the junction of the first sealing layer (30) and the middle sealing layer (40).

8. The radio frequency module waterproof structure according to claim 6 or 7, wherein the first sealing layer (60) is connected to first plugs (80) corresponding to the first jacks (60); and the middle sealing layer (40) is connected to second plugs (85) corresponding to the second jacks (70).

9. The radio frequency module waterproof structure according to claim 8, wherein multiple annular recessed portions are disposed in inner peripheral walls of the first and the second jacks (60); and protrusions opposite to the recessed portions are disposed at outer peripheral edges of the first plugs (80) and the second plugs (85).

10. The radio frequency module waterproof structure according to any one of claims 1 to 9, wherein the first sealing layer (30), the second sealing layer (50), and the middle sealing layer (40) are made of a rubber material.

11. A radio frequency module, comprising the radio frequency module waterproof structure according to any one of claims 1 to 10, the radio frequency module **characterised in that** external high-density cables of the radio frequency module are inserted into the first jacks (60) and second jacks (70), a cover body (20) is fastened to the case body (10), the first sealing layer (30), a second sealing layer (50), and a middle sealing layer (40) are sandwiched by the cover body (20) and the case body (10), and the first sealing layer (30), the second sealing layer (50), and the middle sealing layer (40) seal the high-density cables.

## Patentansprüche

1. Wasserdichte Struktur für ein Hochfrequenzmodul, wobei die wasserdichte Struktur einen Gehäusekörper (10), einen Abdeckkörper (20), eine erste Dichtungsschicht (30), eine mittlere Dichtungsschicht (40) und eine zweite Dichtungsschicht (50) umfasst, die erste Dichtungsschicht (30) auf dem Gehäusekörper (10) montiert ist und die zweite Dichtungsschicht (50) auf dem Abdeckkörper (20) montiert ist und gegenüber der ersten Dichtungsschicht (30) angeordnet ist;
der Abdeckkörper (20) den Gehäusekörper (10) bedeckt und die mittlere Dichtungsschicht (40) zwischen der ersten Dichtungsschicht (30) und der zweiten Dichtungsschicht (50) angeordnet ist;
an einer Verbindungsstelle der ersten Dichtungsschicht (30) und der mittleren Dichtungsschicht (40) mindestens zwei erste Steckerbuchsen (60) ausgebildet sind; und
an einer Verbindungsstelle der zweiten Dichtungsschicht (50) und der mittleren Dichtungsschicht (40) mindestens zwei zweite Steckerbuchsen (70) ausgebildet sind und die mindestens zwei ersten Steckerbuchsen (60) und die mindestens zwei zweiten Steckerbuchsen (70) in zwei Schichten übereinander verteilt und versetzt angeordnet sind, wobei ein Stützkörper (42) in der mittleren Dichtungsschicht (40) eingewickelt ist und der Stützkörper (42) und die mittlere Dichtungsschicht (40) durch Insert-Spritzgussverfahren gebildet werden, wobei der Stützkörper (42) ein Metallstück ist, das die gleiche Form wie die der mittleren Dichtungsschicht (40) und eine Größe aufweist, die kleiner als die der mittleren Dichtungsschicht (40) ist.

2. Wasserdichte Struktur für ein Hochfrequenzmodul nach Anspruch 1, wobei mindestens zwei nebeneinander angeordnete erste Nuten (33), die bogenförmige Querschnitte aufweisen, auf einer Oberfläche angeordnet sind, die aus der ersten Dichtungsschicht (30) besteht und die der mittleren Dichtungsschicht (40) zugewandt ist, zweite Nuten (44), die den ersten Nuten (33) entsprechen, an der mittleren Dichtungsschicht (40) angeordnet sind und die zweiten Nuten (44) und die ersten Nuten (33) entsprechend gekoppelt sind, um die ersten Steckerbuchsen (60) zu bilden.

3. Wasserdichte Struktur für ein Hochfrequenzmodul nach Anspruch 2, wobei mindestens zwei nebeneinander angeordnete dritte Nuten (55), die bogenförmige Querschnitte aufweisen, auf einer Oberfläche angeordnet sind, die aus der zweiten Dichtungsschicht (50) besteht und die der mittleren Dichtungsschicht (40) zugewandt ist, vierte Nuten (46), die den dritten Nuten (55) entsprechen, an der mittleren Dichtungsschicht (40) angeordnet sind, und die dritten Nuten (55) und die vierten Nuten (46) entsprechend gekoppelt sind, um die zweiten Steckerbuchsen (70) zu bilden.

4. Wasserdichte Struktur für ein Hochfrequenzmodul nach Anspruch 2, wobei die erste Dichtungsschicht (30) eine erste Montagefläche (34) und zwei gegenüberliegende erste Endflächen (35) umfasst, die mit der ersten Montagefläche (34) verbunden sind, und die mindestens zwei ersten Nuten (33) nebeneinander auf der ersten Montagefläche (34) angeordnet sind, und zwei Enden der mindestens zwei ersten Nuten (33) die beiden ersten Endflächen (35) durchdringen.

5. Wasserdichte Struktur für ein Hochfrequenzmodul nach Anspruch 3, wobei die mittlere Dichtungsschicht (40) ferner zwei gegenüberliegend angeordnete zweite Montageflächen (41) und zwei gegenüberliegend angeordnete zweite Endflächen (43) umfasst, die zwei zweiten Endflächen (43) jeweils mit den beiden zweiten Montageflächen (41) verbunden sind und die zweiten Nuten (44) auf einer der zweiten Montageflächen (41) angeordnet sind; und
die mindestens zwei dritten Nuten (46) auf der anderen zweiten Montagefläche (41) angeordnet sind, und zwei Enden der zweiten Nuten (46) und zwei Enden der mindestens zwei dritten Nuten (46) die beiden zweiten Endflächen (43) durchdringen.

6. Wasserdichte Struktur für ein Hochfrequenzmodul nach einem der Ansprüche 1 bis 5, wobei die erste Dichtungsschicht (30) und die mittlere Dichtungsschicht (40) unter Verwendung eines Verbindungsstreifens verbunden sind.

7. Wasserdichte Struktur für ein Hochfrequenzmodul nach Anspruch 1, wobei die erste Dichtungsschicht (30) und die mittlere Dichtungsschicht (40) mittels eines integrierten Formteils verbunden sind und die ersten Steckerbuchsen (60) Durchgangslöcher sind, die runde Querschnitte aufweisen und die an der Verbindungsstelle der ersten Dichtungsschicht (30) und der mittleren Dichtungsschicht (40) angeordnet sind.

8. Wasserdichte Struktur für ein Hochfrequenzmodul nach Anspruch 6 oder 7, wobei die erste Dichtungsschicht (60) mit ersten Steckern (80) verbunden ist, die den ersten Stecker (60) entsprechen; und
die mittlere Dichtungsschicht (40) mit zweiten Steckern (85) verbunden ist, die den zweiten Steckerbuchsen (70) entsprechen.

9. Wasserdichte Struktur für ein Hochfrequenzmodul nach Anspruch 8, wobei mehrere ringförmige vertiefte Abschnitte in inneren Umfangswänden der ersten und der zweiten Steckerbuchsen (60) angeordnet sind; und
Vorsprünge, die den vertieften Abschnitten gegenüberliegen, an den äußeren Umfangskanten der ersten Stecker (80) und der zweiten Stecker (85) angeordnet sind.

10. Wasserdichte Struktur für ein Hochfrequenzmodul nach einem der Ansprüche 1 bis 9, wobei die erste Dichtungsschicht (30), die zweite Dichtungsschicht (50) und die mittlere Dichtungsschicht (40) aus einem Gummimaterial bestehen.

11. Hochfrequenzmodul, umfassend die wasserdichte Struktur für ein Hochfrequenzmodul nach einem der Ansprüche 1 bis 10, wobei das Hochfrequenzmodul **dadurch gekennzeichnet ist, dass** externe High-Density-Kabel des Hochfrequenzmoduls in die ersten Steckerbuchsen (60) und die zweiten Steckerbuchsen (70) eingeführt werden, ein Abdeckkörper (20) an dem Gehäusekörper (10) befestigt ist, die erste Dichtungsschicht (30), eine zweite Dichtungsschicht (50) und eine mittlere Dichtungsschicht (40) zwischen dem Abdeckkörper (20) und dem Gehäusekörper (10) angeordnet sind und die erste Dichtungsschicht (30), die zweite Dichtungsschicht (50) und die mittlere Dichtungsschicht (40) die High-Density-Kabel abdichten.

## Revendications

1. Structure étanche de module de radiofréquence, dans laquelle la structure étanche comprend un corps de boîtier (10), un corps de couvercle (20), une première couche d'étanchéité (30), une couche d'étanchéité intermédiaire (40) et une seconde couche d'étanchéité (50), la première couche d'étanchéité (30) est montée sur le corps de boîtier (10), et la seconde couche d'étanchéité (50) est montée sur le corps de couvercle (20) et est disposée en face de la première couche d'étanchéité (30) ;
le corps de couvercle (20) recouvre le corps de boîtier (10), et la couche d'étanchéité intermédiaire (40) est prise en sandwich entre la première couche d'étanchéité (30) et la seconde couche d'étanchéité (50) ;
au moins deux premiers vérins (60) sont formés à une jonction de la première couche d'étanchéité (30) et de la couche intermédiaire d'étanchéité (40) ; et
au moins deux seconds vérins (70) sont formés à une jonction de la seconde couche d'étanchéité (50) et de la couche intermédiaire d'étanchéité (40), et des au moins deux premiers vérins (60) et les au moins deux seconds vérins (70) sont répartis en deux couches, l'une au-dessus de l'autre, et sont disposés de manière échelonnée, dans lequel un corps de support (42) est enveloppé à l'intérieur de la couche d'étanchéité intermédiaire (40), et le corps de support (42) et la couche d'étanchéité intermédiaire (40) sont formés au moyen d'un moulage par insertion, dans lequel le corps de support (42) est une pièce métallique qui a la même forme que celle de la couche d'étanchéité intermédiaire (40) et une taille inférieure à celle de la couche d'étanchéité intermédiaire (40).

2. Structure étanche de module radiofréquence selon la revendication 1, dans laquelle au moins deux premières rainures disposées de façon adjacente (33) qui ont des sections transversales en forme d'arc sont disposées sur une surface qui provient de la première couche d'étanchéité (30) et qui fait face à la couche d'étanchéité intermédiaire (40), les secondes rainures (44) correspondant aux premières rainures (33) sont disposées au niveau de la couche d'étanchéité intermédiaire (40), et les deuxièmes rainures (44) et les premières rainures (33) sont couplées de manière correspondante pour former le premiers vérins (60).

3. Structure étanche de module radiofréquence selon la revendication 2, dans laquelle au moins deux troisièmes rainures (55) disposées de manière adjacente qui ont des sections transversales en forme d'arc sont disposées sur une surface qui provient de la seconde couche d'étanchéité (50) et qui fait face à la couche d'étanchéité intermédiaire (40), les quatrièmes rainures (46) correspondant aux troisièmes rainures (55) sont disposées au niveau de la couche d'étanchéité intermédiaire (40), et les troisièmes rainures (55) et les quatrièmes rainures (46) sont accouplées de manière correspondante pour former le deuxièmes vérins (70).

4. Structure étanche de module radiofréquence selon la revendication 2, dans laquelle la première couche d'étanchéité (30) comprend une première surface de montage (34) et deux premières surfaces d'extrémité opposées (35) reliées à la première surface de montage (34), et au moins deux premières rainures (33) sont disposées de manière adjacente sur la première surface de montage (34), et deux extrémités des au moins deux premières rainures (33) pénètrent dans les deux premières surfaces d'extrémité (35).

5. Structure étanche de module radiofréquence selon la revendication 3, dans laquelle la couche d'étanchéité intermédiaire (40) comprend en outre deux secondes surfaces de montage (41) disposées de façon opposée et deux secondes surfaces d'extrémité (43) disposées de façon opposée, les deux secondes surfaces d'extrémité (43) sont respectivement reliées aux deux secondes surfaces de montage (41), et les secondes rainures (44) sont disposées sur l'une des secondes surfaces de montage (41) ; et
les au moins deux troisièmes rainures (46) sont disposées sur l'autre deuxième surface de montage (41), et deux extrémités des deuxièmes rainures (46) et deux extrémités des au moins deux troisièmes rainures (46) pénètrent dans les deux secondes surfaces d'extrémité (43).

6. Structure étanche de module radiofréquence selon l'une quelconque des revendications 1 à 5, dans laquelle la première couche d'étanchéité (30) et la couche d'étanchéité intermédiaire (40) sont reliées en utilisant une bande de liaison.

7. Structure étanche de module radiofréquence selon la revendication 1, dans laquelle la première couche d'étanchéité (30) et la couche d'étanchéité intermédiaire (40) sont reliées au moyen d'un moulage intégré, et les premiers vérins (60) sont des trous traversants qui ont des sections transversales rondes et qui sont disposés à la jonction de la première couche d'étanchéité (30) et de la couche d'étanchéité intermédiaire (40).

8. Structure étanche de module radiofréquence selon la revendication 6 ou la revendication 7, dans laquelle la première couche d'étanchéité (60) est reliée à des premières fiches (80) correspondant aux premiers vérins (60) ; et
la couche d'étanchéité intermédiaire (40) est reliée à des secondes fiches (85) correspondant aux seconds vérins (70).

9. Structure étanche de module de radiofréquence selon la revendication 8, dans laquelle de multiples parties annulaires en retrait sont disposées dans les parois périphériques intérieures des premier et second vérins (60) ; et
des saillies opposées aux parties en retrait sont disposées sur les bords périphériques externes des premières fiches (80) et des secondes fiches (85).

10. Structure étanche de module radiofréquence selon l'une quelconque des revendications 1 à 9, dans laquelle la première couche d'étanchéité (30), la deuxième couche d'étanchéité (50) et la couche d'étanchéité intermédiaire (40) sont constituées d'un matériau en caoutchouc.

11. Module radiofréquence, comprenant la structure étanche du module radiofréquence selon l'une quelconque des revendications 1 à 10, le module radiofréquence étant **caractérisé en ce que** des câbles externes à haute densité du module radiofréquence sont insérés dans les premiers vérins (60) et les seconds vérins (70), un corps de couvercle (20) est fixé au corps de boîtier (10), la première couche d'étanchéité (30), une seconde couche d'étanchéité (50) et une couche d'étanchéité intermédiaire (40) sont prises en sandwich par le corps du couvercle (20) et le corps de boîtier (10), et la première couche d'étanchéité (30), la deuxième couche d'étanchéité (50) et la couche d'étanchéité intermédiaire (40) scellent les câbles à haute densité.
